# EUROPEAN PATENT SPECIFICATION

(11) **EP 2 405 489 B1**
(45) Date of publication and mention of the grant of the patent: **10.04.2019**
(21) Application number: 10007100.0
(22) Date of filing: 09.07.2010
(51) Int. Cl.: H01L 31/048, H02S 40/44

(54) **High-efficiency solar cell and method for its production**
Hocheffiziente Solarzelle und Verfahren zu deren Herstellung
Cellule solaire haute efficacité et son procédé de production

(43) Date of publication of application: 11.01.2012
(73) Proprietor: Fraunhofer-Gesellschaft zur Förderung der angewandten Forschung e.V., 80686 München (DE)
(72) Inventor: Dupeyrat, Patrick, 79106 Freiburg (DE); Rommel, Matthias, 8320 Fehraltorf (CH); Wirth, Harry, 79249 Merzhausen (DE)
(74) Representative: Pfenning, Meinig & Partner mbB

(56) References cited:
- EP-A1- 0 789 404
- EP-A2- 0 755 079
- EP-A2- 0 820 105
- DE-A1- 10 304 061
- DE-A1- 19 809 883
- US-A- 4 587 376

## Description

The present invention relates to a high-efficiency solar cell for photovoltaic thermal hybrid collector applications based on a new concept for encapsulation of the solar cell. This concept provides better optical performance than the photovoltaic thermal hybrid systems known in the prior art. The present invention further relates to a method for producing this high-efficiency solar cell.

In conventional photovoltaic thermal modules, the solar cells are protected by a glass cover plate and the rigidity of the metallic heat exchanger. In general, a conventional crystalline silicon solar cell module is made of inter-connected crystalline silicon solar cells laminated between two layers out of ethylene vinyl acetate. Moreover, such module comprises a transparent front side made of glass and a reflective back side thin layer usually made of polyvinyl fluoride (white Tedlar®). Such a setup has the disadvantage that the performance of the crystalline silicon solar cells is reduced by optical losses due to the high absorption of ethylene vinyl acetate below wavelength of 400 nm and of additional reflection losses at the inter-phase between air and glass.

It was therefore an object of the present invention to overcome the disadvantages of the prior art and to provide a solar cell with an improved performance in view of the optical and electrical properties.

This object is solved by the solar cell with the features of claim 1, the photovoltaic thermal collector with the features of claim 8 and the method for its production with the features of claim 11. The further dependent claims describe preferred embodiments.

According to a first aspect, the present invention provides a high-efficiency solar cell for photovoltaic thermal hybrid applications which comprises a textured crystalline silicon solar cell and, deposited on the front side of the solar cell in this sequence, an additional anti-reflective coating and a first polymer film. The rear-side and the edges of the solar cell are encapsulated in a second, electrically insulating polymer having a thermal expansion coefficient from 20 to 200 10⁻⁶K⁻¹ and a conductivity from 0,1 to 10 W/(m.K).

It is a characterizing aspect of the present invention that the first polymer film has a lower refractive index than the anti-reflective coating and the anti-reflective coating has a lower refractive index than the solar cell and the near UV absorbance of polymer film and anti-reflective coating is lower than the near UV absorbance of ethylene-vinyl acetate.

The solar cells according to the present invention show the following advantages:
- a better thermal contact between solar cell and the metallic heat exchanger,
- a better reliability,
- better optical properties due to the use of low refractive materials on the front side resulting in a higher absorption,
- better electrical properties due to the use of a combination of Lacquer and polymer giving a very low absorption in the UV in comparison with modules known from the prior art.

The anti-reflective coating has a thickness of 1 to 500 µm and is a transparent lacquer.

Preferably, the polymer material of the polymer film has a thermal expansion coefficient from 1 to 200-10⁻⁶ K⁻¹. The polymer material of the polymer film is preferably heat resistant up to a temperature of 130 °C, more preferably up to a temperature of 200 °C. The polymer material of the polymer film is preferably selected from the group consisting of fluoropolymers, preferably fluorinated ethylene-propylene, ethylene tetrafluoroethylene, polytetrafluoroethylene, perfluoromethyl vinyl ether, polyvinyl fluoride and its compounds or silicone polymer and its compounds.

Preferably, the second polymer is selected from the group consisting of ethylene-vinyl acetate, polyvinyl butyrate, thermoplastic vulcanizates, thermoplastic silicone elastomers and its compounds.

It is an advantage of the present invention that the solar cell does not necessarily comprise a glass cover plate.

According to a second aspect, the present invention provides a photovoltaic thermal collector comprising the above-described solar cell deposited on a metallic or plastic heat exchanger.

Preferably, the metallic heat exchanger is made from aluminium, copper, iron, steel and mixtures thereof.

The polymer used for encapsulating the solar cell has a thermal expansion coefficient to compensate the difference of the thermal expansion coefficients of silicon (i.e. the solar cell) and the metal selected for the metallic heat exchanger. Moreover, it is preferred that the heat exchanger comprises an electrical insulating coating.

According to a third aspect, the present invention provides a method for producing a photovoltaic thermal collector as described above, which comprises the following steps:
At first, a heat exchanger with at least one flat surface is coated with an electrically insulating layer.

In a second step, a solar cell is coated with an additional anti-reflective coating which is a transparent lacquer having a thickness of 1 to 500 µm.

Such coated solar cell is subsequently laminated on the back side with ethylene vinyl acetate and the heat exchanger and simultaneously laminated on the front-side with a fluoropolymer, preferably fluorinated ethylene-propylene, ethylene tetrafluoroethylene, polytetrafluoroethylene, perfluoromethyl vinyl ether, polyvinyl fluoride and its compounds or with silicone polymer and its compounds.

Subsequently, the laminated solar cell is integrated in a collector frame.

It will be appreciated that the invention is not restricted to the details described above. With reference to the preferred embodiments, numerous modifications and variations can be made without departing from the invention as defined in the claims.

The present invention will now be described in detail with reference to the following figures and examples, which by no means shall limit the scope of the invention.
Figure 1 shows an inventive photovoltaic thermocollector.
Figure 2 shows reflection measurements on laminated sc-Si cell (a), laminated black coating (b), non-laminated pc-Si cell (c) and non-laminated sc-Si cell (d) .
Figure 3 shows thermal efficiency measurements at the without PV extraction (plus-signs) and polynomial fit of measurements (dashed line). Corresponding coefficients: a0 = 0.88; heat loss coefficients a1 = 7.00 (linear part) and a2 = 0.026 (quadratic part).
Figure 4 shows thermal efficiency measurements under PV operation at maximal power point (plus-signs: thermal; circles: electrical) and polynomial fit of the measurements (dashed line). Corresponding thermal coefficients: a0 = 0.79; heat loss coefficients a1 = 6.36 (linear part) and a2 = 0.035 (quadratic part).
Figure 5 shows thermal efficiency curve measurements using an indoor solar simulator of: (a) an existing PV-T collector under PV operation, (b) a thermal collector with selective absorber, (c) our newly developed PV-T collector under PV operation conditions.
Figure 6 shows EQE and reflection measurements on laminated samples.

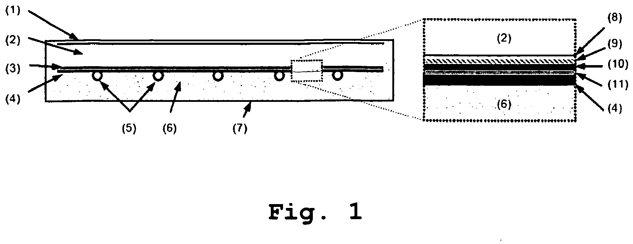

Fig. 1 shows an inventive photovoltaic thermocollector with a collector glass cover 1, a static air layer 2, photovoltaic cells on modules 3, an absorber sheet 4, which can be a metal coated with an electric insulating layer. The collector further comprises tubes 5 for cooling the fluid flowing in the tubes and a thermal insulation 6 on the back and the edge of the collector. Furthermore, the collector comprises a frame 7, a front polymer 8, which can be a fluoro-polymer and a solar cell specific coating 9 as well as an interconnected c-Si solar cell 10 and an IEVA film 11. In the following the functions of each component are described:
1 and 7 protect the absorber and the solar cell from ambient.
1 and 2 reduce the front side thermal losses of the collector.
6 reduce the thermal losses on the edge and bottom of the collector.
4 and 5 is a flat heat exchanger within a cooling fluid flows in order to remove the heat from the solar module.
4, 5, 8, 9, 10, 11 are laminated together in order to build a PVT absorber plate.
8 and 9 are the optimized optical layer to encapsulate the solar cell (front side).
11 and 4 encapsulate the solar cell in the back side.

### Example 1

### Lamination

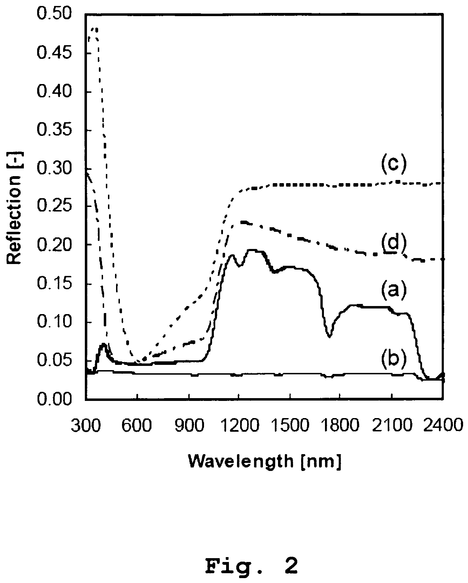

A thick aluminium absorber was laminated with inter-connected PV cells located between two EVA films and a highly transparent cover with low refractive index. A vacuum laminator using standard PV lamination conditions was used in order to obtain a functional PV-T laminate. The dimensions of the aluminium absorber were 570 x 1100 x 1.2 mm and the heat exchanger geometry was designed in order to achieve a good homogeneous temperature distribution. To ensure electrical isolation of the solar cells from the metal absorber, a coating was applied on the surface of the aluminium absorber. The same coating serves as the radiation absorbing surface for those areas which are not covered by PV cells. Both EVA films were 0.5 mm thick, and a 0.13 mm thick highly transparent flexible polymer film was used as front layer. 18 Pseudo square sc-Si PV cells (156 x 156 x 0.2 mm) were connected in series and laminated. The PV cell reference efficiency was 16% and the ratio between the solar cell active area and the full absorber surface (packing factor) was 0.67, which is much less than the value of 0.85 used for simulation. No delamination between PV encapsulant and metal absorber was observed after all tests were carried out; but of course a thorough durability analysis is necessary in the future. Optical reflection measurements were carried out on the laminated PV-T absorber using an integrating sphere (also called Ulbricht sphere) and the results are presented in the Figure 2. Curve (a) corresponds to the reflection measured in the middle of an encapsulated sc-Si solar cell. Curve (b) corresponds to the reflection measured in the encapsulated black coating. Curves (c) and (d) represent the reflection measurements made in the centre of a non-laminated pc-Si solar cell (c) and a sc-Si solar cell (d), respectively. All reflection measurement surface areas were 10 x 12 mm².

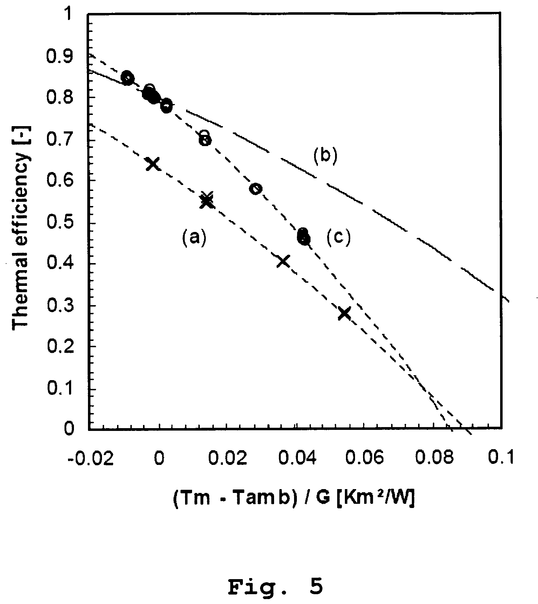

By assuming that radiation which is not reflected is absorbed, it is possible to extract from those measurements the solar absorption coefficient. Using the experimental results presented in the Figure 5 and after mathematical integration with the solar spectrum according to the norm ISO 9050, the absorption coefficient of the laminated black coating and the laminated sc-Si cell are 0.96 and 0.93, respectively. Therefore the absorption coefficient for the whole PV-T plate is estimated to be 0.94, whereas the absorption coefficient of a standard thermal collector is about 0.95.

### Collector description

A single glazed flat plate PV-T collector was built using two of these PV-T laminates connected in parallel. The outer dimensions of the experimental collector were 1360 x 1350 x 120 mm and the absorber area was 1.27 m². Both PV-T laminates are electrically connected in series. The front cover was 3 mm thick low-iron glass with an anti-reflective coating. The resulting normal transmission coefficient was measured to be 0.94. The thermal insulation on the back of the absorber is 60 mm thick and the edge insulation is 40 mm thick. The thermal conductivity of the insulation material is 0.035 W/(m.K). The distance between glass cover and PV-T laminate is 45 mm. The performance of this PV-T collector was measured at the indoor solar simulator test facility of Fraunhofer ISE. The efficiency values presented below are based on the absorber surface area.

### Collector testing

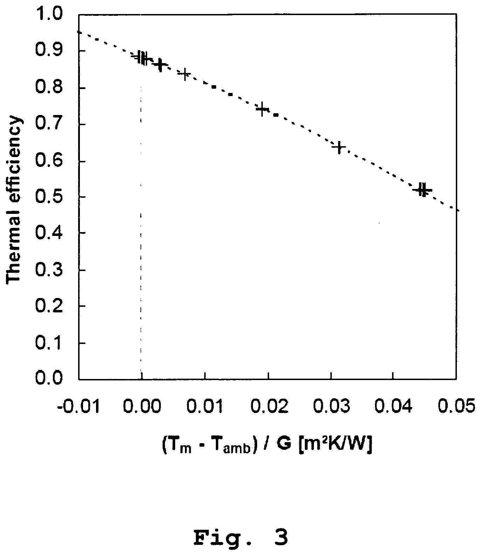

Thermal measurements on the developed PV-T collector were carried out according to EN12975. During the measurements, the ambient temperature varied between 33 and 36 °C, an artificial wind was applied with a velocity of 3 m/s (in a parallel direction to the collector front glass), a water flow rate of 72 kg/hr/m² was used and the collector tilt angle was 45°. In the first set of measurements, the interconnected PV cells were not connected to a maximum power point (mpp) tracker. As experiments were carried out in open-circuit conditions, all absorbed solar radiation was converted into heat. The Figure 3 presents the results of these measurements and the corresponding thermal efficiency curve (polynomial fit). At zero reduced temperature, the thermal efficiency (a0) is around 0.88. A typical value for a standard flat-plate collector is around 0.8. But compared to a standard flat plate collector our PV-T testing collector uses a highly transparent glass cover and a thermal absorber with a good optimized channel grid and thus a high collector efficiency factor F'.

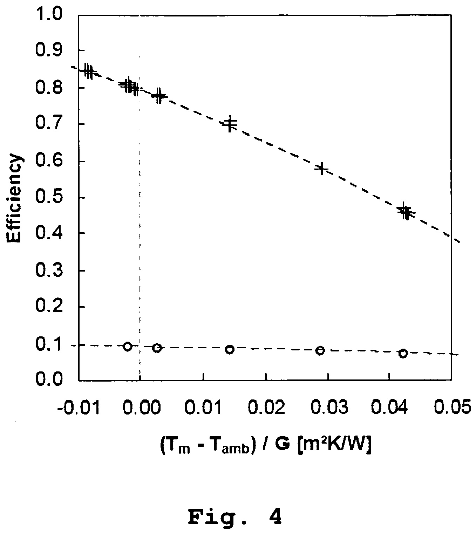

In the second set of measurements, the interconnected PV cells were connected to a mpp tracker and therefore the incoming radiation which is converted into electricity was extracted from the collector. Figure 4 presents the corresponding thermal and electrical efficiency measurements (respectively plus-signs and circles) as a function of the reduced temperature, and the polynomial fit curves.

According to the polynomial fit of the thermal measurements, the thermal efficiency at zero reduced temperature is 79% with a corresponding electrical efficiency of 8.8%, leading to an overall efficiency of 88%.

The thermal and electrical performance was measured and compared to those of a marketed PV-T collector and a selective thermal collector (Fig. 5).

### Example 2

### Scientific innovation and relevance:

For single glazed flat-plate PV-T collectors, inter-connected solar cells, EVA layers and transparent front side (glass for example) can be laminated together on the surface of a coated metal heat exchanger which improves the heat transfer between PV cells and cooling fluid. In opposition to conventional modules the protection of the solar cells is brought for the PV-T module by the additional glass cover and the rigidity by the metal heat exchanger. Therefore, the glass pane is no longer necessary as module front glazing and alternative encapsulant materials can be investigated. They can be selected to provide better optical/electrical properties.

### Experiment:

An encapsulation process has been developed, consisting of a combination of a low refractive index front layer instead of glass cover and a low UV absorbent layer instead of EVA. Mc-Si cells were encapsulated and the electrical performances of the encapsulated mc-Si were investigated (EQE, I(U) and reflection measurement). Mono crystalline silicon solar cells (12.5 x 12.5 cm²) have been prepared: interconnections were soldered onto the busbars of the each cell in order to perform electrical test before encapsulation: I(U) curves and EQE were measured on each solar cell in order to control their homogeneity in term of performances. Then, the mono-Si solar cells have been encapsulated in individual mini-modules. The structure of the mini-modules was a conventional Glass/EVA/cell/EVA/Tedlar for the first series of module (a), and combination of a fluoropolymer low refractive index front layer instead of glass cover and a low UV absorbent encapsulant coating instead of EVA laminated on a hard substrate for the second series of module (b). EVA foils were 500 µm thick and a curing temperature of 130°C was applied for 13 min. 1 mm thick anodized aluminium substrate was use for the backside of module b. The conventional glass used for the first module was a 3 mm thick low-iron glass with a solar transmission up to 91%, whereas the fluoro-polymer foil used for the modules (b) was 120µm thick with a solar transmission up to 94%.

### Results:

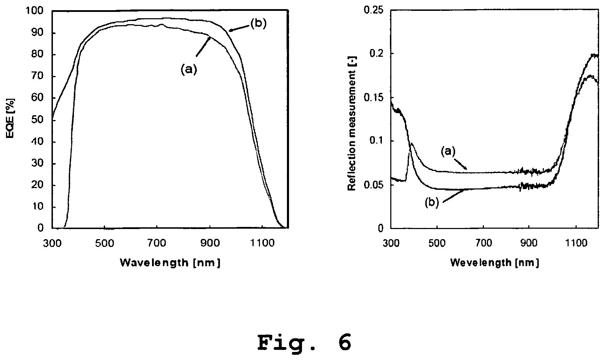

EQE and reflection measurements were done on both laminated kinds of samples (Fig. 6). In opposition to module (a), no cut-off due to encapsulant (EVA) absorption is observed by module (b). Additionally, the reflection losses are lower due to a better optical matching between the module and the air. This lead to an increase greater than 1.5 mA/cm² in generated current density (calculated according to EQE measurement) for our module, compared to a conventional standard Glass/EVA/mc-Si/EVA/Tedlar module.

## Claims

1. High-efficiency solar cell for photovoltaic thermal hybrid applications comprising
a textured crystalline silicon solar cell and,
deposited in this order on the front side of the solar cell, an additional anti-reflective coating and a first polymer film, wherein the rear-side and the edges of the solar cell are encapsulated in a second, electrically insulating polymer having a thermal expansion coefficient from 20 to 200 10⁻⁶K⁻¹ and a conductivity from 0,1 to 10 W/(m.K), **characterised in that**
the first polymer film has a lower refractive index than the additional anti-reflective coating and the additional anti-reflective coating has a lower refractive index than the solar cell and the UV absorbance of the first polymer film and additional anti-reflective coating is lower than the UV absorbance of ethylene-vinyl acetate,
wherein the polymer material of the first polymer film is selected from the group consisting of fluoropolymers, silicone polymer and silicone polymer compounds, and wherein the anti-reflective coating is a transparent lacquer having a thickness of 1 to 500 µm.

2. Solar cell of claim 1, **characterised in that** the polymer material of the first polymer film has a thermal expansion coefficient from 1 to 200·10⁻⁶ K⁻¹.

3. Solar cell of any of the preceding claims, **characterised in that** the polymer material of the first polymer film and the additional anti-reflective coating is heat resistant up to a temperature of 130 °C, preferably of 200 °C.

4. Solar cell of any of the preceding claims, **characterised in that** the polymer material of the first polymer film is UV resistant.

5. Solar cell of any of the preceding claims, **characterised in that** the polymer material of the first polymer film is selected from the group consisting of fluorinated ethylene-propylene, ethylene tetrafluoroethylene, polytetrafluoroethylene, perfluoromethyl vinyl ether, polyvinyl fluoride and its compounds.

6. Solar cell of any of the preceding claims, **characterised in that** the second polymer is selected from the group consisting of ethylene-vinyl acetate, polyvinyl butyrate, thermoplastic vulcanizates, thermoplastic silicone elastomers and its compounds.

7. Solar cell of any of the preceding claims, **characterised in that** the solar cell does not comprise a glass cover plate.

8. Photovoltaic thermal collector comprising a solar cell of any of the preceding claims deposited on a metallic or plastic heat exchanger.

9. Photovoltaic thermal collector of claim 8, **characterised in that** the metallic heat exchanger is made from aluminium, copper, iron, steel and mixtures thereof.

10. Photovoltaic thermal collector of claim 8 or 9, **characterised in that** the encapsulating polymer has a thermal expansion coefficient to compensate the difference of the thermal expansion coefficients of silicon and the metal selected for the metallic heat exchanger.

11. Method for producing a photovoltaic thermal collector of any of the claims 8 to 10, in which
a) a heat exchanger having at least one flat surface is coated with an electrically insulating layer,
b) a solar cell is coated with an additional anti-reflective coating,
c) the coated solar cell is laminated on the back-side with ethylene vinyl acetate and the heat exchanger and on the front-side with a fluoropolymer, and
d) the laminated solar cell is integrated in a collector frame.

## Patentansprüche

1. Hocheffiziente Solarzelle für photovoltaisch-thermische Hybridanwendungen, enthaltend
eine texturierte, kristalline Silizium-Solarzelle und,
in dieser Reihenfolge auf der Vorderseite der Solarzelle platziert, eine zusätzliche Antireflexionsbeschichtung und eine ersten Polymerfolie,
wobei die Rückseite und die Kanten der Solarzelle in einem zweiten, elektrisch isolierenden Polymer mit einer thermischen Ausdehnungskoeffizient von 20 bis 200 10⁻⁶K⁻¹ und einer Leitfähigkeit von 0,1 bis 10 W/(m.K) eingekapselt sind,
**dadurch gekennzeichnet, dass**
die erste Polymerfolie einen niedrigeren Brechungsindex aufweist als die zusätzliche Antireflexionsbeschichtung und die zusätzliche Antireflexionsbeschichtung einen niedrigeren Brechungsindex aufweist als die Solarzelle und
die UV-Absorption der ersten Polymerfolie und zusätzlichen Antireflexionsbeschichtung geringer ist als die UV-Absorption von EthylenVinylacetat,
wobei das Polymermaterial der ersten Polymerfolie ausgewählt ist aus der Gruppe bestehend aus Fluorpolymeren, Silikonpolymer und Silikon-polymeren Verbindungen und
wobei die Antireflexionsbeschichtung ein transparenter Lack mit einem Dicke von 1 bis 500 µm ist.

2. Solarzelle nach Anspruch 1, **dadurch gekennzeichnet, dass** das Polymermaterial der ersten Polymerfolie einen thermischen Ausdehnungskoeffizienten von 1 bis 200·10⁻⁶K⁻¹ hat.

3. Solarzelle nach einem der vorhergehenden Ansprüche, **dadurch gekennzeichnet, dass** das Polymermaterial der ersten Polymerfolie und der zusätzlichen Antireflexionsbeschichtung bis zu einer Temperatur von 130 °C, vorzugsweise 200 °C, hitzebeständig ist.

4. Solarzelle nach einem der vorhergehenden Ansprüche, **dadurch gekennzeichnet, dass** das Polymermaterial der ersten Polymerfolie UVbeständig ist

5. Solarzelle nach einem der vorhergehenden Ansprüche, **dadurch gekennzeichnet, dass** das Polymermaterial der ersten Polymerfolie ausgewählt ist aus der Gruppe bestehend aus fluoriertes Ethylen-Propylen, Ethylen-Tetrafluorethylen, Polytetrafluorethylen, Perfluormethylvinylether, Polyvinylfluorid und seine Verbindungen.

6. Solarzelle nach einem der vorhergehenden Ansprüche, **dadurch gekennzeichnet, dass** das zweite Polymer ausgewählt ist aus der Gruppe bestehend aus Ethylen-Vinyl-Acetat, Polyvinylbutyrat, thermoplastische Vulkanisate, thermoplastisch Silikonelastomere und deren Verbindungen.

7. Solarzelle nach einem der vorhergehenden Ansprüche, **dadurch gekennzeichnet, dass** die Solarzelle keine Glasabdeckplatte aufweist.

8. Photovoltaischer Wärmekollektor enthaltend eine Solarzelle nach einem der vorhergehenden Ansprüche, platziert auf einem Metall- oder Kunststoff-Wärmetauscher

9. Photovoltaischer Wärmekollektor nach Anspruch 8, **dadurch gekennzeichnet, dass** der Metallwärmetauscher aus Aluminium, Kupfer, Eisen, Stahl und Mischungen davon gemacht ist.

10. Photovoltaischer Wärmekollektor nach Anspruch 8 oder 9, **dadurch gekennzeichnet, dass** das verkapselnde Polymer einen Wärmeausdehnungskoeffizienten zur Kompensierung der Differenz der Wärmeausdehnungskoeffizienten von Silizium und des für den Metall-Wärmetauschers ausgewählten Metalls aufweist.

11. Verfahren zur Herstellung eines photovoltaischen Wärmekollektors nach einem der Ansprüche 8 bis 10, in dem
a) ein Wärmetauscher, der mindestens eine flache Oberfläche hat, mit einer elektrisch isolierende Schicht beschichtet wird,
b) eine Solarzelle mit einer zusätzlichen Antireflexionsbeschichtung beschichtet wird,
c) die beschichtete Solarzelle auf der Rückseite mit Ethylen-Vinyl-Acetat und dem Wärmetauscher und auf der Vorderseite mit einem Fluorpolymer laminiert wird, und
d) die laminierte Solarzelle in einen Kollektorrahmen integriert wird.

## Revendications

1. Cellule solaire à rendement élevé destinée à des applications hybrides thermiques photovoltaïques, comprenant
une cellule solaire à silicium cristallin qui présente une texture, et un revêtement anti-réfléchissant supplémentaire et un premier film polymère, déposés dans cet ordre sur la face avant de la cellule solaire,
où la face arrière et les bords de la cellule solaire sont enrobés dans un second polymère isolant électriquement présentant un coefficient de dilatation thermique compris entre 20 et 200·10⁻⁶K⁻¹ et une conductivité comprise entre 0,1 et 10 W/(m.K),
**caractérisée en ce que**
le premier film polymère présente un indice de réfraction inférieur à celui du revêtement anti-réfléchissant supplémentaire, et le revêtement anti-réfléchissant supplémentaire présente un indice de réfraction inférieur à celui de la cellule solaire, et l'absorbance des UV du premier film polymère et du revêtement anti-réfléchissant supplémentaire est inférieure à l'absorbance des UV de l'acétate de vinyle - éthylène,
où le matériau polymère du premier film polymère est sélectionné dans le groupe constitué par des polymères fluorés, des polymères de silicone et des composés de polymères de silicone, et
où le revêtement anti-réfléchissant est une laque transparente présentant une épaisseur comprise entre 1 et 500 µm.

2. Cellule solaire selon la revendication 1, **caractérisée en ce que** le matériau polymère du premier film polymère présente un coefficient de dilatation thermique compris entre 1 et 200·10⁻⁶K⁻¹.

3. Cellule solaire selon l'une quelconque des revendications précédentes, **caractérisée en ce que** le matériau polymère du premier film polymère et du revêtement anti-réfléchissant supplémentaire est résistant à la chaleur jusqu'à une température égale à 130 °C, de préférence égale à 200 °C.

4. Cellule solaire selon l'une quelconque des revendications précédentes, **caractérisée en ce que** le matériau polymère du premier film polymère est résistant aux UV.

5. Cellule solaire selon l'une quelconque des revendications précédentes, **caractérisée en ce que** le matériau polymère du premier film polymère est sélectionné dans le groupe constitué par un éthylène - propylène fluoré, un tétrafluoroéthylène d'éthylène, un polytétrafluoroéthylène, un perfluoro (méthyle vinyle éther), un polyfluorure de vinyle, et des composés de ceux-ci.

6. Cellule solaire selon l'une quelconque des revendications précédentes, **caractérisée en ce que** le second polymère est sélectionné dans le groupe constitué par un acétate de vinyle - éthylène, un butyrate polyvinyle, des vulcanisats thermoplastiques, des élastomères de silicones thermoplastiques, et des composés de ceux-ci.

7. Cellule solaire selon l'une quelconque des revendications précédentes, **caractérisée en ce que** la cellule solaire ne comprend aucune couverture de verre.

8. Collecteur thermique photovoltaïque comprenant une cellule solaire selon l'une quelconque des revendications précédentes, déposée sur un échangeur de chaleur métallique ou en matière plastique.

9. Collecteur thermique photovoltaïque selon la revendication 8, **caractérisé en ce que** l'échangeur de chaleur métallique est réalisé en aluminium, en cuivre, en fer, en acier et dans des mélanges de ceux-ci.

10. Collecteur thermique photovoltaïque selon la revendication 8 ou 9, **caractérisé en ce que** le polymère d'enrobage présente un coefficient de dilatation thermique destiné à compenser la différence des coefficients de dilatation thermique du silicium et du métal sélectionné pour l'échangeur de chaleur métallique.

11. Procédé de production d'un collecteur thermique photovoltaïque selon l'une quelconque des revendications 8 à 10, dans lequel
a) un échangeur de chaleur présentant au moins une surface plate, est revêtu d'une couche isolante électriquement,
b) une cellule solaire est revêtue d'un revêtement anti-réfléchissant supplémentaire,
c) la cellule solaire revêtue est stratifiée sur le côté arrière, avec un acétate de vinyle - éthylène et l'échangeur de chaleur, et sur la face avant, avec un polymère fluoré, et
d) la cellule solaire stratifiée est intégrée dans un bâti de collecteur.
